# EUROPÄISCHE PATENTSCHRIFT

(11) **EP 3 535 121 B1**
(45) Veröffentlichungstag und Bekanntmachung des Hinweises auf die Patenterteilung: **25.10.2023**
(21) Anmeldenummer: 17787384.1
(22) Anmeldetag: 18.10.2017
(51) Int. Cl.: B32B 17/10, C03C 27/12

(54) **VERFAHREN ZUR HERSTELLUNG EINER VERBUNDSCHEIBE MIT FUNKTIONSELEMENT**
METHOD OF PRODUCING A LAMINATED PANE WITH FUNCTIONAL ELEMENT
PROCÉDÉ DE PRODUCTION D'UNE VITRE FEUILLETÉ COMPRENANT UN ÉLÉMENT FONCTIONNEL

(30) Priorität: 02.11.2016 EP 16196847
(43) Veröffentlichungstag der Anmeldung: 11.09.2019
(73) Patentinhaber: SAINT-GOBAIN GLASS FRANCE, 92400 Courbevoie (FR)
(72) Erfinder: KIZMAZ, Ali-Osman, 52146 Würselen (DE); MERCKS, Horst, 52068 Aachen (DE); GOERENZ, Walter, 52146 Würselen (DE)
(74) Vertreter: Gebauer, Dieter Edmund
(86) Internationale Anmeldenummer: PCT/EP2017/076528
(87) Internationale Veröffentlichungsnummer: WO 2018/082920

(56) Entgegenhaltungen:
- EP-A1- 2 955 164
- DE-A1- 2 248 094
- US-A- 2 644 065
- US-A- 4 645 970
- US-A1- 2005 238 857
- US-A1- 2015 165 965

## Beschreibung

Die Erfindung betrifft ein Verfahren zur Herstellung einer Verbundscheibe mit Funktionselement.

Es sind Verglasungen, insbesondere Verbundscheiben mit Funktionselementen, bekannt, deren optische Eigenschaften veränderlich sind. Die Funktionselemente sind häufig elektrisch schalt- oder regelbar. Die optischen Eigenschaften der Funktionselemente können dabei durch eine angelegte Spannung verändert werden. Ein Beispiel sind SPD-Funktionselemente (*suspendedparticle device*), die beispielsweise aus EP 0876608 B1 und WO 2011033313 A1 bekannt sind. Durch die angelegte Spannung lässt sich die Transmission von sichtbarem Licht steuern. Verglasungen mit solchen Funktionselementen können also auf komfortable Weise elektrisch abgedunkelt werden.

Ein weiteres Beispiel für Funktionselemente mit elektrisch regelbaren optischen Eigenschaften sind OLED-Displays (*organic light emitting diode*)*.* Damit können Verglasungen erzeugt werden, die eine integrierte Anzeigefläche enthalten. Das OLED-Display kann beispielsweise in einer Windschutzscheibe eines Kraftfahrzeugs genutzt werden, um Informationen für den Fahrer einzublenden oder den Rückspiegel zu ersetzen. Solche Lösungen sind beispielsweise aus US20110025584A1 oder WO2015041106A1 bekannt.

Die Funktionselemente werden häufig als vorgefertigtes Mehrschichtelement bereitgestellt, das sich einfach in Verbundgläser integrieren lässt. Dazu werden die Funktionselemente in einer thermoplastischen Zwischenschicht eingebettet und zwischen zwei Glasscheiben laminiert. Typischerweise wird die thermoplastische Zwischenschicht aus mehreren Folien hergestellt, von denen eine mit einer Aussparung versehen ist, in welche das Funktionselement im Wesentlichen passgenau eingesetzt wird. Solche Herstellungsverfahren sind beispielsweise aus WO2007122429A1, WO2007122426A1 oder WO2014083111A1 bekannt.

Eine solche Integration der Funktionselemente funktioniert problemlos, solange die thermoplastische Folie mit der Aussparung und das Funktionselement eine ähnliche Dicke aufweisen. Werden die thermoplastische Folie und das Funktionselement von ihren jeweiligen Herstellern aber mit sehr unterschiedlicher Dicke bereitgestellt, so tritt ein Versatz auf, der beim Aneinanderpressen des Schichtstapels bei der Lamination zu optischen Verzerrungen führen kann oder sogar zum Bruch der Glasscheibe oder zur Beschädigung des Funktionselements.

US2005238857A1 offenbart eine Verbundscheibe mit integriertem LED-Funktionselement. Es wird vorgeschlagen, das Funktionselement mit einer polymeren Beschichtung zu versehen, um die adhäsive Verbindung zu den benachbarten Schichten zu gewährleisten und etwaige Dickenunterschiede zwischen dem Funktionselement und der es umgebenden Folie der Zwischenschicht zu kompensieren. Das Funktionselement eigens mit einem polymeren Material in der erforderlichen optischen Qualität und der gewünschten Schichtdicke zu beschichten, ist jedoch verfahrenstechnisch aufwendig. Auch können Dickenunterschiede nur dann ausgeglichen werden, wenn die Dicke des Funktionselements geringer ist als die Dicke der sie umgebenden Folie der Zwischenschicht.

EP 2955164A1, US2644065A und DE2248094A1 offenbaren Verbundscheiben mit integrierten Funktionselementen unterschiedlicher Art. Das Funktionselement ist dabei nicht von einer einzelnen rahmenartigen Folie umgeben. Stattdessen wird der Rahmen um das Funktionselement durch zwei übereinanderliegende, mit einer Aussparung versehenen Folien gleicher Dicke gebildet. Damit keine Dickenunterschiede auftreten, ist es hierbei erforderlich, dass die Dicke des Funktionselements etwa der doppelten Foliendicke verfügbarer Standard-Zwischenschichtfolien entspricht. Das Verfahren ist daher nicht mit der gewünschten Flexibilität einsetzbar, um beliebige Dickenunterschiede zu kompensieren.

Es besteht daher Bedarf an verbesserten Verfahren zur Herstellung von Verbundscheiben mit integrierten Funktionselementen, die zu einer hohen optischen Qualität führen und Glasbruch vermeiden, wenn das Funktionselement und die thermoplastischen Folien unterschiedliche Dicken aufweisen. Die Aufgabe der vorliegenden Erfindung ist es, ein solches verbessertes Herstellungsverfahren bereitzustellen.

Die Aufgabe der vorliegenden Erfindung wird erfindungsgemäß durch ein Verfahren zur Herstellung einer Verbundscheibe gemäß dem unabhängigen Anspruch 1 gelöst. Bevorzugte Ausführungen gehen aus den Unteransprüchen hervor.

Das erfindungsgemäße Verfahren umfasst mindestens das Anordnen eines Funktionselements in einer Aussparung einer thermoplastischen Rahmenfolie, das flächigkongruente Anordnen der thermoplastischen Rahmenfolie mit dem Funktionselement zwischen einer ersten Glasscheibe und einer zweiten Glasscheibe zu einem Schichtstapel und das anschließende Verbinden des Schichtstapels zu einer Verbundscheibe durch Lamination. Das Funktionselement weist insbesondere veränderliche optische Eigenschaften auf, die beispielsweise den Lichttransmissionsgrad, den Lichtstreuungsgrad, die Lichtpolarisation oder die Emission von Licht betreffen können. Die Aussparung ist bevorzugt etwa kongruent zum Funktionselement ausgebildet, wobei eine kleine Lücke zwischen Aussparungsrand und Funktionselement von beispielsweise kleiner als 5 mm, bevorzugt kleiner 1 mm akzeptabel ist, so dass die Aussparung auch geringfügig größer ausgebildet sein kann als das Funktionselement. Der thermoplastische Rahmen um das Funktionselement kann auch durch mehrere kongruent übereinanderliegende Rahmenfolien, bevorzugt gleicher Dicke, gebildet werden.

Unter der Aussparung wird im Sinne der Erfindung eine durchgehende Ausnehmung in der Rahmenfolie verstanden, gleichsam ein ausgedehntes Loch oder eine Durchführung. Die Aussparung wird häufig auch als *Cut-Out* bezeichnet, weil sie typischerweise durch Ausschneiden eines Bereichs der Rahmenfolie hergestellt wird.

Die thermoplastische Rahmenfolie und das Funktionselement weisen eine unterschiedliche Dicke auf. Dadurch bildet sich ein Versatz aus, wenn das Funktionselement in die Aussparung eingesetzt wird: die gemeinsame Oberfläche weist eine Stufe auf am Übergang von thermoplastischer Rahmenfolie zu Funktionselement. Dieser Versatz kann bei der späteren Lamination Probleme verursachen. Ist das Funktionselement dicker als die Rahmenfolie, so entstehen Druckkräfte auf das Funktionselement selbst. Ist das Funktionselement dünner als die Rahmenfolie, so entstehen nach der Lamination Zugkräfte, die axial auf das Funktionselement wirken. Beides kann das Funktionselement beschädigen. Außerdem können sich optische Verzerrungen ausbilden oder die Glasscheiben können brechen. Der Versatz kann auch als Stufe innerhalb des Schichtstapels bezeichnet werden. Sie wirkt sich als lokale Änderung der Gesamtdicke aller Bestandteile des Schichtstapels aus.

Der erfinderische Gedanke besteht nun darin, den Dickenunterschied zwischen der Rahmenfolie und dem Funktionselement zumindest teilweise zu kompensieren oder auszugleichen durch mindestens eine thermoplastische Ausgleichsfolie. Dadurch sollen Stufen mit kritischer Höhe vermieden werden. Durch Verwendung der Ausgleichsfolie wird der auftretende Versatz verringert. Der maximale Versatz ist also geringer als der Dickenunterschied zwischen Rahmenfolie und Funktionselement, der sich ohne Verwendung der Ausgleichsfolie als Versatz ergeben würde. Idealerweise entspricht der maximale auftretende Versatz höchstens der Dicke der Ausgleichsfolie oder ist sogar geringer. Mit dem Ausdruck der zumindest teilweisen Kompensation ist gemeint, dass der Versatz durch die Ausgleichsfolie natürlich nicht vollständig verschwindet, sondern abgemildert wird.

Um den Versatz verringern zu können, muss die Ausgleichsfolie eine Dicke aufweisen, die weniger als doppelt so groß ist wie der Dickenunterschied, also die Höhe des Versatzes zwischen Rahmenfolie und Funktionselement. Idealerweise ist die Dicke der Ausgleichsfolie geringer als der Dickenunterschied zwischen Rahmenfolie und Funktionselement. Die Größe des Versatzes hängt wesentlich von der Dicke der Ausgleichsfolie ab, wobei der genaue Zusammenhang von der Ausführungsform abhängt, wie untenstehend erläutert wird.

Durch die Verwendung der Ausgleichsfolie tritt im Schichtstapel bevorzugt kein Versatz von größer 100 µm auf.

In einer besonders bevorzugten Ausführung tritt im Schichtstapel kein Versatz von größer 50 µm auf. Die Erfinder haben festgestellt, dass bereits bei einem solchen Versatz die Gefahr von optischen Verzerrungen und sogar Glasbruch besteht. Es ist natürlich nur sinnvoll, hierfür eine Ausgleichsfolie einzusetzen, wenn der Dickenunterschied zwischen der thermoplastischen Rahmenfolie und dem Funktionselement größer als 50 µm beträgt.

Die erfindungsgemäße Ausgleichsfolie unterscheidet sich von der Rahmenfolie insbesondere durch ihre Dicke, wobei die Ausgleichsfolie eine wesentlich geringere Dicke aufweist als die Rahmenfolie. Dadurch können beliebig ausgeprägte Dickenunterschiede flexibel kompensiert werden. Die Dicke der Ausgleichsfolie beträgt beispielsweise höchsten ein Fünftel der Dicke der Rahmenfolie.

Hinsichtlich des Dickenunterschieds können zwei Fälle auftreten: die Dicke der Rahmenfolie kann größer oder kleiner sein als die Dicke des Funktionselements.

In einer ersten Ausführungsform der Erfindung ist die Dicke der thermoplastischen Rahmenfolie größer als die Dicke des Funktionselements. Dadurch wird die Aussparung der Rahmenfolie nicht vollständig durch das Funktionselement ausgefüllt und im Schichtstapel würde ein leerer Raum innerhalb der Aussparung verbleiben. Um den Dickenunterschied zu kompensieren, wird die thermoplastische Ausgleichsfolie auf dem Funktionselement innerhalb der Aussparung angeordnet. Die Ausgleichsfolie ist in diesem Fall bevorzugt im Wesentlichen kongruent zur Aussparung und zum Funktionselement ausgebildet. Es können auch mehrere Ausgleichsfolien übereinander auf dem Funktionselement angeordnet werden, insbesondere wenn der Dickenunterscheid mindestens das 1 ,5-fache oder sogar mindestens das Doppelte der Dicke der Ausgleichsfolie beträgt. Der Fachmann wird in Sinne der Erfindung so viele Ausgleichsfolie auf dem Funktionselement anordnen, wie nötig sind, so dass entweder der übrigbleibende leere Raum innerhalb der Aussparung eine geringere Dicke aufweist als die Ausgleichsfolie oder die oberste Ausgleichsfolie teilweise noch innerhalb der Aussparung angeordnet ist und teilweise über die Aussparung übersteht. Auf beide Arten lässt sich der Versatz im Vergleich zur Situation ohne Ausgleichsfolie reduzieren.

In der ersten Ausführungsform kann der Versatz verringert werden, wenn die Ausgleichsfolie eine Dicke aufweist, die weniger als doppelt so groß ist wie der Dickenunterschied zwischen Rahmenfolie und Funktionselement. Ist die Dicke der Ausgleichsfolie größer als der Dickenunterscheid, so steht die Ausgleichsfolie über die Aussparung in der Rahmenfolie über, der verbleibende Versatz ist aber verringert. Besonders gute Ergebnisse werden erreicht, wenn die Dicke der Ausgleichsfolie geringer als der Dickenunterschied zwischen Rahmenfolie und Funktionselement ist.

Die erste Ausführungsform ist also zusammengefasst ein Verfahren zur Herstellung einer Verbundscheibe, mindestens umfassend das Anordnen eines Funktionselements in einer Aussparung einer thermoplastischen Rahmenfolie, das Anordnen der thermoplastischen Rahmenfolie mit dem Funktionselement zwischen einer ersten Glasscheibe und einer zweiten Glasscheibe zu einem Schichtstapel und das anschließende Verbinden des Schichtstapels zu einer Verbundscheibe durch Lamination, wobei die thermoplastische Rahmenfolie eine größere Dicke aufweist als das Funktionselement und wobei eine Ausgleichsfolie, deren Dicke weniger als doppelt so groß ist wie die Differenz der Dicken der thermoplastischen Rahmenfolie und des Funktionselements, auf dem Funktionselement innerhalb der Aussparung angeordnet wird.

In einer zweiten Ausführungsform der Erfindung ist die Dicke der thermoplastischen Rahmenfolie kleiner als die Dicke des Funktionselements. Das Funktionselement steht also über die Aussparung über. Um den Dickenunterschied zu kompensieren, wird die thermoplastische Ausgleichsfolie auf der thermoplastischen Rahmenfolie rahmenartig um die Aussparung angeordnet. Rahmenartig bedeutet, dass die Ausgleichsfolie die Aussparung im Wesentlichen vollständig umgibt. Die rahmenartige Ausgleichsfolie wird bevorzugt etwa bündig zur Aussparung angeordnet. Eine rahmenartige Ausgleichsfolie ist gleichsam eine Ausgleichsfolie, die ihrerseits eine Aussparung aufweist, wobei die Aussparungen der Rahmenfolie und der Ausgleichsfolie bevorzugt etwa kongruent sind, so dass sie bündig angeordnet werden können. Die Ausgleichsfolie umgibt also den überstehenden Teil des Funktionselements. Auch in dieser Ausführungsform ist es natürlich möglich, bei Bedarf mehrere rahmenartige Ausgleichsfolien übereinander anzuordnen.

Durch eine Ausgleichsfolie, deren Dicke größer ist als der Dickenunterschied zwischen Rahmenfolie und Funktionselement, aber weniger als doppelt so groß ist wie besagter Dickenunterschied, kann die am Rand des Funktionselements verbleibende Stufe in der zweiten Ausführungsform ebenfalls verringert werden. Allerdings würde an der vom Funktionselement abgewandten Seitenkante der Ausgleichsfolie ein Versatz erzeugt, der der Dicke der Ausgleichsfolie entspricht. In der zweiten Ausführungsform sind daher nur solche Ausgleichsfolien sinnvoll, deren Dicke geringer ist als der Dickenunterschied zwischen Rahmenfolie und Funktionselement.

Die zweite Ausführungsform ist also zusammengefasst ein Verfahren zur Herstellung einer Verbundscheibe, mindestens umfassend das Anordnen eines Funktionselements in einer Aussparung einer thermoplastischen Rahmenfolie, das Anordnen der thermoplastischen Rahmenfolie mit dem Funktionselement zwischen einer ersten Glasscheibe und einer zweiten Glasscheibe zu einem Schichtstapel und das anschließende Verbinden des Schichtstapels zu einer Verbundscheibe durch Lamination, wobei die thermoplastische Rahmenfolie eine geringere Dicke aufweist als das Funktionselement und wobei mindestens eine Ausgleichsfolie, deren Dicke geringer ist als die Differenz der Dicken der thermoplastischen Rahmenfolie und des Funktionselements, auf der thermoplastischen Rahmenfolie rahmenartig um die Aussparung angeordnet wird.

Je breiter die rahmenartige Ausgleichsfolie ist, desto weniger wird die darüberliegende Glasscheibe bei der Lamination gebogen und desto wirksamer können optische Verzerrungen und mechanische Spannungen vermieden werden. Die Obergrenze wird dabei durch die Größe der Verbundscheibe bestimmt, so dass die Ausgleichsfolie maximal etwa kongruent zur Rahmenfolie ausgebildet ist. Ausgleichsfolien mit geringerer Breite sind allerdings kostengünstiger, weil Material eingespart wird. Die Ausgleichsfolie erstreckt sich daher bevorzugt nicht bis zu den Seitenkanten der Rahmenfolie, beziehungsweise der Verbundscheibe, ist also nicht kongruent zur Rahmenfolie ausgebildet, sondern weist eine geringere Fläche auf als die Rahmenfolie. Die Breite der rahmenartigen Ausgleichsfolie beträgt bevorzugt mindestens das 200-fache der Dicke der Ausgleichsfolie, bevorzugt mindestens das 500-fache. Damit wird die Verbiegung der darüberliegenden Glasscheibe auf ein Maß reduziert, das gute Laminierungsergebnisse gewährleistet. Typischerweise beträgt die Breite bevorzugt mindestens 10 mm, besonders bevorzugt mindestens 15 mm. Unter der Breite der rahmenartigen Ausgleichsfolie (Rahmenbreite) wird die Distanz zwischen dem inneren, der Aussparung zugewandten Begrenzungsrand und dem äußeren, von der Aussparung abgewandten Begrenzungsrand der Ausgleichsfolie verstanden.

Ist der Dickenunterschied zwischen Rahmenfolie und Funktionselement größer als das 1,5-fache, insbesondere größer als das Doppelte der Dicke der Ausgleichsfolie, so werden in einer besonders vorteilhaften Variante der zweiten Ausführungsform mehrere Ausgleichsfolien übereinander auf der Rahmenfolie angeordnet und jeweils rahmenartig um die Aussparung angeordnet, wobei die Breite der Ausgleichsfolien mit wachsendem Abstand zur Rahmenfolie abnimmt. Die Ausgleichsfolien sind also gleichsam pyramidenartig übereinander angeordnet, so dass jede Ausgleichsfolie eine Stufe zur darunterliegenden Ausgleichsfolie (beziehungsweise im Fall der untersten Ausgleichsfolie zur darunterliegenden Rahmenfolie) erzeugt. So wird das Auftreten von großen Stufen wirksam verhindert und Spannungen bei der Lamination werden vermieden. Der Fachmann wird im Sinne der Erfindung so viele Ausgleichsfolie auf der Rahmenfolie anordnen, wie nötig sind, so dass entweder die übrigbleibende Stufe von der obersten Ausgleichsfolie zum Funktionselement eine Höhe aufweist, die gering ist als die Dicke der Ausgleichsfolie, oder die oberste Ausgleichsfolie teilweise über das Funktionselement übersteht. Die Breite jeder Stufe des pyramidenartigen Stapels an Ausgleichsfolien beträgt bevorzugt mindestens das 200-fache der Dicke der Ausgleichsfolie, bevorzugt mindestens das 500-fache.

In beiden Ausführungsformen der Erfindung kann die Ausgleichsfolie einstückig ausgebildet sein, was hinsichtlich einer einfacheren Handhabung vorteilhaft und daher bevorzugt ist. Die Ausgleichsfolie kann grundsätzlich aber auch aus mehreren nebeneinandergelegten Stücken zusammengesetzt werden.

Das Material der thermoplastischen Ausgleichsfolie kann vom Fachmann grundsätzlich den Erfordernissen des Einzelfalls entsprechend gewählt werden. Bevorzugt sollte ein Material gewählt werden, das geeignet ist, beim Laminieren eine adhäsive Verbindung zu den direkt mit der Ausgleichsfolie in Kontakt stehenden polymeren Schichten oder Glasscheiben (mit Ausnahme des Funktionselements) herzustellen, also insbesondere zur thermoplastischen Rahmenfolie und darüberliegenden Glasscheiben oder optionalen weiteren thermoplastischen Schichten, die zwischen der Glasscheibe und der Rahmenfolie angeordnet sein können.

Die Ausgleichsfolie enthält besonders bevorzugt Polyvinylbutyral (PVB), Ethylenvinylacetat (EVA) und/oder Polyurethan (PU), insbesondere PVB. Da diese Materialien für die thermoplastische Zwischenschicht von Verbundscheiben üblich sind und auch eine adhäsive Verbindung zu Glas herstellen, ist eine gute Verbindung gewährleistet.

Es ist aber auch denkbar, dass keine adhäsive Verbindung gewünscht ist, sondern gleichsam eine mechanische Entkopplung. In diesem Fall ist beispielsweise Polyethylenterephthalat (PET) als Material geeignet.

Je dünner die Ausgleichsfolie ist, desto wirksamer können Versatze vermieden werden, jedoch sind thermoplastische Folien nicht beliebig dünn herstellbar. Die thermoplastische Ausgleichsfolie weist bevorzugt eine Dicke von 25 µm bis 100 µm, besonders bevorzugt von 40 µm bis 70 µm, insbesondere etwa 50 µm auf. Damit können gute Ergebnisse hinsichtlich der Reduzierung von mechanischen Spannungen erreicht werden.

Je härter eine thermoplastische Folie ist, desto dünner kann sie hergestellt, insbesondere extrudiert werden. Die Ausgleichsfolie weist daher bevorzugt eine möglichst geringe Menge an Weichmacher auf, um sie möglichst dünn herstellen zu können. Übliche thermoplastische Folien, insbesondere solche aus PVB, weisen einen Weichmacheranteil von mindestens 15 Gew.-% auf. Die Ausgleichsfolie weist bevorzugt einen demgegenüber reduzierten Wert auf. Bevorzugt enthält die Ausgleichsfolie einen Weichmacheranteil von kleiner als 15 Gew.-%, besonders bevorzugt kleiner als 10 Gew.-%, ganz besonders bevorzugt kleiner als 5 Gew.-% und ist insbesondere im Wesentlichen weichmacherfrei.

Die Erfindung ist grundsätzlich auf alle Funktionselemente anwendbar, die einen Dickenunterschied zur Rahmenfolie aufweisen. Das Funktionselement ist insbesondere ein Funktionselement mit veränderlichen optischen Eigenschaften. Die Veränderung der optischen Eigenschaften kann dabei passiv ohne Einflussnahme des Benutzers erfolgen, wie beispielsweise im Falle eines photochromen Funktionselements oder eines Polfilters, oder aktiv durch Einflussnahme des Benutzers beispielsweise durch Änderung der an das Funktionselement angelegten elektrischen Spannung.

Das Funktionselement ist bevorzugt ein Funktionselement mit elektrisch schalt- oder regelbaren optischen Eigenschaften. Das Funktionselement kann beispielsweise ein SPD-, ein PDLC- oder ein elektrochromes Funktionselement sein.

Bei einem SPD-Funktionselement (*suspended particle device*) enthält die aktive Schicht suspendierte Partikel, wobei die Absorption von Licht durch die aktive Schicht mittels Anlegen einer Spannung an die Flächenelektroden veränderbar ist. Die Absorptionsänderung beruht auf der Ausrichtung der stäbchenartigen Partikel im elektrischen Feld bei angelegter elektrischer Spannung. SPD-Funktionselemente sind beispielsweise aus EP 0876608 B1 und WO 2011033313 A1 bekannt.

Bei einem PDLC-Funktionselement (*polymer dispersed liquid crystal*) enthält die aktive Schicht Flüssigkristalle, welche in eine Polymermatrix eingelagert sind. Wird an die Flächenelektroden keine Spannung angelegt, so sind die Flüssigkristalle ungeordnet ausgerichtet, was zu einer starken Streuung des durch die aktive Schicht tretenden Lichts führt. Wird an die Flächenelektroden eine Spannung angelegt, so richten sich die Flüssigkristalle in einer gemeinsamen Richtung aus und die Transmission von Licht durch die aktive Schicht wird erhöht. Ein solches Funktionselement ist beispielsweise aus DE 102008026339 A1 bekannt.

Bei einem elektrochromen Funktionselement ist die aktive Schicht des Funktionselements eine elektrochemisch aktive Schicht. Die Transmission von sichtbarem Licht ist vom Einlagerungsgrad von Ionen in die aktive Schicht abhängig, wobei die Ionen beispielsweise durch eine lonenspeicherschicht zwischen aktiver Schicht und einer Flächenelektrode bereitgestellt werden. Die Transmission kann durch die an die Flächenelektroden angelegte Spannung, welche eine Wanderung der Ionen hervorruft, beeinflusst werden. Geeignete funktionelle Schichten enthalten beispielsweise zumindest Wolframoxid oder Vanadiumoxid. Elektrochrome Funktionselemente sind beispielsweise aus WO 2012007334 A1, US 20120026573 A1, WO 2010147494 A1 und EP 1862849 A1 bekannt.

In einer besonders bevorzugten Ausführung der Erfindung ist das Funktionselement ein elektrolumineszentes Funktionselement, insbesondere ein OLED-Display. Dabei enthält die aktive Schicht elektrolumineszente Materialen, insbesondere organische elektrolumineszente Materialen, deren Lumineszenz durch Anlegen einer Spannung angeregt wird. Elektrolumineszente Funktionselemente sind beispielsweise aus US 2004227462 A1 und WO 2010112789 A2 bekannt. Das elektrolumineszente Funktionselement kann als einfache Lichtquelle verwendet werden, oder als Display, mit dem beliebige Darstellungen erzeigt werden können. Ein solches Display kann beispielsweise in einer Windschutzscheibe dazu verwendet werden, um Informationen für den Fahrer einzublenden. So können beispielsweise die aktuelle Geschwindigkeit oder andere Zustandsparameter angezeigt werden, oder das Bild einer nach hinten gerichteten Kamera wird angezeigt, um den Rückspiegel zu ersetzen. Im Falle eines Displays genügen natürlich keine einfachen Flächenelektroden, die jeweils insgesamt das gleiche Potential aufweisen - vielmehr müssen die einzelnen Pixel separat angesteuert werden. Die hierzu nötigen Maßnahmen sind dem Fachmann an sich bekannt und OLED-Display-Folien kommerziell erhältlich.

Die Erfinder haben erkannt, dass OLED-Displays besonders druckempfindlich sind und außerdem kommerziell nicht mit solchen Dicken verfügbar sind, die etwa den Dicken üblicher kommerziell erhältlicher thermoplastischer Folien entsprechen. Daher ist das Auftreten von Versatz bei der Herstellung von Verbundscheiben mit OLED-Displays besonders wahrscheinlich und gleichzeitig besonders kritisch. Die Vorteile der Erfindung entfalten sich daher bei der Herstellung eben solcher Verbundscheiben in besonderer Weise, weswegen sie bevorzugt ist.

Das Funktionselement wird bevorzugt als Mehrschichtelement bereitgestellt. Das Mehrschichtelement enthält eine aktive Schicht, die im Falle von elektrisch schalt- oder regelbaren Funktionselementen flächig zwischen einer zwei transparenten Flächenelektrode angeordnet ist. Die aktive Schicht stellt die schalt- oder regelbaren Eigenschaften bereit, während der Schaltzustand durch die an die Flächenelektroden angelegte Spannung gewählt werden kann. Die Flächenelektroden, welche beispielsweise als dünne Silber- oder ITO-Schichten realisiert sein können, werden dazu mit einer externen Spannungsquelle auf an sich bekannte Art elektrisch verbunden, insbesondere über geeignete Verbindungskabel, beispielsweise Folienleiter. Die äußeren Schichten des Mehrschichtelements werden beidseitig durch isolierende, transparente Trägerschichten gebildet, beispielsweise polymere Trägerfolien, meist aus Polyethylenterephthalat (PET) mit Dicken von 0,1 mm bis 0,5 mm, oder sehr dünne Glasschichten mit ähnlichen Dicken. Das Mehrschichtelement enthält also in der angegebenen Reihenfolge zumindest eine Trägerschicht, eine aktive Schicht und eine weitere Trägerschicht. Im Falle von elektrisch schalt- oder regelbaren Funktionselementen enthält das Mehrschichtelement in der angegebenen Reihenfolge zumindest eine Trägerschicht, eine Flächenelektrode, eine aktive Schicht, eine weitere Flächenelektrode und eine weitere Trägerschicht. Solche Mehrschichtelemente sind kommerziell erhältlich und können leicht in das Verbundglas eingebracht werden. Das Mehrschichtelement kann mit einer Randversiegelung versehen werden, um die Diffusion von chemischen Bestandteilen der thermoplastischen Folien, beispielsweise Weichmacher, in die aktive Schicht zu verhindern. Dadurch wird die Alterung des schaltbaren Funktionselements vermindert. Die Randversiegelung ist beispielsweise als Polyimid-haltiger Film oder Folie ausgebildet, welche umlaufend um die Seitenkanten des Mehrschichtelements verläuft.

Die Rahmenfolie kann direkt mit der ersten und/oder zweiten Glasscheibe in Kontakt stehen. In einer bevorzugten Ausgestaltung ist die Rahmenfolie mit dem Funktionselement über jeweils eine weitere thermoplastische Folie mit jeder Glasscheibe verbunden. Zwischen der Rahmenfolie und der ersten Glasscheibe ist dann mindestens eine erste thermoplastische Verbindungsfolie und zwischen der Rahmenfolie und der zweiten Glasscheibe mindestens eine zweite thermoplastische Verbindungsfolie angeordnet. Die Verbindungsfolien weisen bevorzugt keine Aussparungen auf und bedecken die gesamte Rahmenfolie samt ihrer Aussparung.

Die Lamination des Schichtstapels zur Verbundscheibe erfolgt typischerweise unter Einwirkung von Hitze, Vakuum und/oder Druck. Es können an sich bekannte Verfahren zur Lamination verwendet werden, beispielsweise Autoklavverfahren, Vakuumsackverfahren, Vakuumringverfahren, Kalanderverfahren, Vakuumlaminatoren oder Kombinationen davon.

Die Lamination umfasst typischerweise das Entlüften des Schichtstapels, bevorzugt bei Raumtemperatur, und das anschließende Aufschmelzen der thermoplastischen Folie zur Herstellung des Verbunds, bevorzugt bei Temperaturen größer als 70 °C.

Die Rahmenfolie und die optionalen Verbindungsfolien enthalten bevorzugt PVB, EVA und/oder PU, besonders bevorzugt PVB. Die Rahmenfolie und die Verbindungsfolien sind bevorzugt aus demselben Material gefertigt, um eine optimale Verbindung zu gewährleisten. Die Ausgleichsfolie basiert bevorzugt auf demselben Polymer, kann sich jedoch insbesondere im Weichmachergehalt von den übrigen Folien unterscheiden. Die Dicke der Rahmenfolie und der optionalen Verbindungsfolien beträgt typischerweise von 0,2 mm bis 2 mm, bevorzugt von 0,3 mm bis 1 mm, beispielsweise 0,38 mm oder 0,76 mm.

Die erste und die zweite Glasscheibe sind bevorzugt aus Kalk-Natron-Glas gefertigt, das als Fensterglas gebräuchlich und kostengünstig ist. Grundsätzlich können aber auch andere Glassorten verwendet werden, wie beispielsweise Borsilikat-Glas, Quarzglas, Aluminosilikatglas. Die Glasscheiben können thermisch oder chemisch vorgespannt sein. Die Dicke der Glasscheiben beträgt beispielsweise von 0,5 mm bis 5 mm, bevorzugt von 1 mm bis 2,5 mm.

Soll die Verbundscheibe gebogen sein, wie es insbesondere im Fahrzeugbereich üblich ist, so werden die Glasscheiben bevorzugt vor der Lamination in ihre endgültige Form gebogen, beispielsweise durch Schwerkraftbiegen oder Pressbiegen.

Die Erfindung wird anhand einer Zeichnung und Ausführungsbeispiele näher erläutert. Die Zeichnung ist eine schematische Darstellung und nicht maßstabsgetreu. Die Zeichnung schränkt die Erfindung in keiner Weise ein. Insbesondere ist die Dicke der Ausgleichsfolie zur Verdeutlichung im Vergleich zu den übrigen Schichten deutlich vergrößert dargestellt. Es zeigen:
- Fig. 1: eine Draufsicht auf eine Rahmenfolie mit Funktionselement,
- Fig. 2: einen Querschnitt durch einen herkömmlichen Schichtstapel,
- Fig. 3: einen Querschnitt durch eine erste Ausgestaltung eines Schichtstapels vor der Lamination,
- Fig. 4: eine Draufsicht auf eine Rahmenfolie mit Funktionselement und Ausgleichsfolie,
- Fig. 5: einen Querschnitt durch eine zweite Ausgestaltung eines Schichtstapels enthaltend die Rahmenfolie nach Fig. 4,
- Fig. 6: einen Querschnitt durch eine weitere Ausgestaltung eines Schichtstapels vor der Lamination und
- Fig. 7: ein Ausführungsbeispiel des erfindungsgemäßen Verfahrens anhand eines Flussdiagramms.

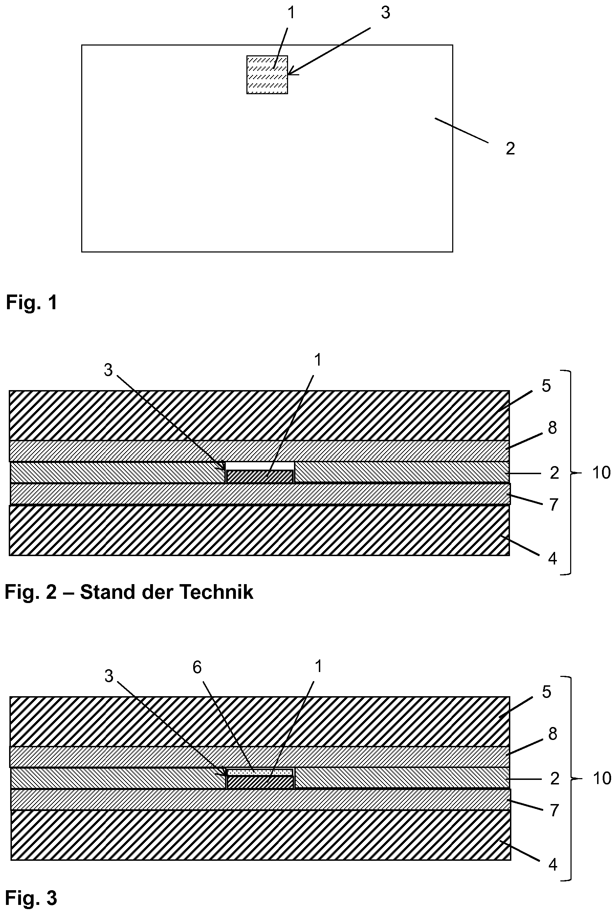

Fig. 1 zeigt eine Draufsicht auf eine Rahmenfolie 2. Die thermoplastische Rahmenfolie 2 ist beispielsweise eine 0,38 mm dicke PVB-Folie. Die Rahmenfolie weist eine rechteckige Aussparung 3 auf, die aus der ursprünglichen Rahmenfolie 2 ausgeschnitten worden ist. In die Aussparung 3 ist ein Funktionselement 1 mit elektrisch regelbaren optischen Eigenschaften, beispielsweise ein als Mehrschichtelement oder -folie ausgebildetes OLED-Display. Die Aussparung 3 und das Funktionselement 1 sind etwa kongruent, so dass das Funktionselement 1 im Wesentlichen passgenau in die Aussparung 3 eingesetzt werden kann.

Das Anordnen eines Funktionselements 1 in einer Aussparung 3 einer Rahmenfolie 2 ist ein übliches Vorgehen, um das Funktionselement 1 in die Zwischenschicht einer Verbundscheibe einzubetten. Idealerweise sollten das Funktionselement 1 und die Rahmenfolie 2 die gleiche Dicke aufweisen. Typischerweise werden die Rahmenfolie 2 und das Funktionselement 1 aber durch den Glashersteller eingekauft, wobei er auf die kommerziell verfügbaren Produkte angewiesen ist. PVB-Folien werden beispielsweise in Standarddicken von 0,38 mm und 0,76 mm angeboten. OLED-Displays sind typischerweise mit davon deutlich unterschiedlichen Dicken erhältlich. Daraus resultiert ein Versatz beim Einsetzen des Funktionselement 1: das Funktionselement 1 füllt die Aussparung 3 nicht komplett aus, wenn es dünner ist als die Rahmenfolie 2, oder ragt aus der Aussparung 3 heraus, wenn es dicker ist als die Rahmenfolie 2.

Fig. 2 zeigt einen Querschnitt durch einen herkömmlichen Schichtstapel 10, der zur Lamination vorbereitet ist. Der Schichtstapel 10 besteht in der angegebenen Reihenfolge aus einer ersten Glasscheibe 4, einer ersten thermoplastischen Verbindungsfolie 7, der Rahmenfolie 2 mit dem in die Aussparung 3 eingesetzten Funktionselement 1, einer zweiten thermoplastischen Verbindungsfolie 8 und einer zweiten Glasscheibe 5. Der Schichtstapel 10 soll zu einer Verbundscheibe laminiert werden, die beispielsweise als Windschutzscheibe vorgesehen ist. Das Funktionselement 1 ist ein OLED-Display und soll im oberen mittigen Bereich der Windschutzscheibe das Bild einer nach hinten gerichteten Kamera anzeigen, um die Funktion des Rückspiegels zu übernehmen. Die Glasscheiben 4, 5 bestehen beispielsweise aus Kalk-Natron-Glas und weisen eine Dicke von 2,1 mm auf. Die Verbindungsfolien 7, 8 sind beispielsweise 0,76 mm dicke PVB-Folien. Die Rahmenfolie 2 ist beispielsweise eine 0,38 mm dicke PVB-Folie und das Funktionselement 1 ist beispielsweise ein 250 µm dickes OLED-Display.

Das Funktionselement 1 ist dünner als die Rahmenfolie 2, wobei die Differenz der Dicken 130 µm beträgt. Dadurch entsteht ein Versatz oder eine Stufe mit einer Höhe von 130 µm beim Übergang von Rahmenfolie 2 zu Funktionselement 1 - er verbleibt ein leerer Raum zwischen Funktionselement 1 und zweiter Verbindungsfolie 8. Beim späteren Laminieren wird ein Anpressdruck auf den Schichtstapel 10 ausgeübt. Durch den leeren Raum besteht die Möglichkeit, dass sich die zweite Glasscheibe 5 im Bereich des Funktionselements 1 stärker biegt, woraus optische Verzerrungen oder sogar ein Bruch der zweiten Glasscheibe 5 resultieren könnten.

Fig. 3 zeigt einen Querschnitt durch eine erste Ausgestaltung eines Schichtstapels 10, der analog zu demjenigen aus Fig. 2 aufgebaut ist. Der 130 µm hohe Versatz ist hier aber durch eine oder mehrere Ausgleichsfolien 6 teilweise kompensiert. Die Ausgleichsfolie 6 ist beispielsweise eine im Wesentlichen weichmacherfreie PVB-Folie mit geringer Dicke. Solche Folien werden beispielsweise von der Firma Kuraray unter dem Markennamen "Mowital LP BF" vertrieben. Die Ausgleichsfolien 6 werden im Wesentlichen kongruent zur Aussparung 3 zurechtgeschnitten, wo dass sie möglichst passgenau in die Aussparung 3 einsetzbar sind. Der Raum zwischen Funktionselement 1 und zweiter Verbindungsfolie 8 wird zumindest teilweise mit der Ausgleichsfolie 6 gefüllt, so dass der Versatz verringert oder sogar ganz beseitigt wird. Beim späteren Laminieren können die vorstehend beschriebenen Probleme dadurch verhindert werden.

Es ist beispielsweise möglich, eine einzelne Ausgleichsfolie 6 mit einer Dicke von 100 µm zu verwenden. Der ursprüngliche Versatz von 130 µm wird dadurch auf einen unkritischen Wert von 30 µm reduziert. Ebenso ist es möglich, zwei übereinandergelegte Ausgleichsfolien 6 mit einer Dicke von jeweils 50 µm zu verwenden.

Alternativ könnten auch drei Ausgleichsfolien 6 mit einer Dicke von jeweils 50 µm verwendet werden (oder eine einzelne Ausgleichsfolie 6 mit einer Dicke von 150 µm). Die Gesamtdicke der Ausgleichsfolien 6 ist größer als der ursprüngliche Versatz und die oberste Ausgleichsfolie 6 steht um einen Versatz von 20 µm über die Aussparung 3 über. Auch auf diese Weise wird der Versatz von ursprünglich 130 µm auf einen unkritischen Wert von nur 20 µm reduziert.

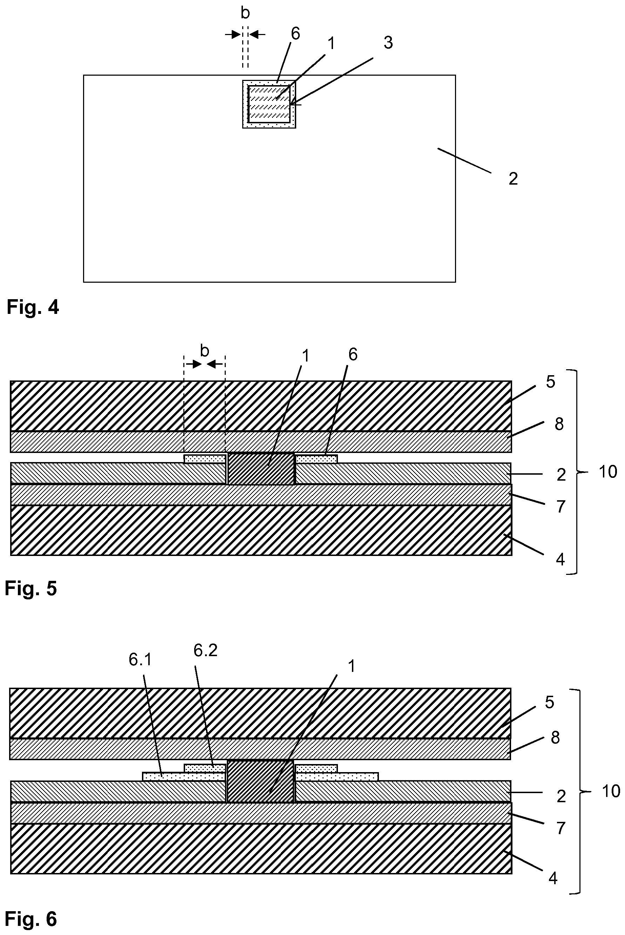

Fig. 4 zeigt eine Draufsicht auf eine weitere Rahmenfolie 2 mit eingesetztem Funktionselement 1. Das Funktionselement 1 weist hier eine Dicke von beispielsweise 450 µm auf und ist damit dicker als die 380 µm dicke Rahmenfolie 2 aus PVB. Das Funktionselement 1 ragt daher aus der Aussparung 3 heraus. Um die unterschiedliche Dicke teilweise zu kompensieren, ist eine Ausgleichsfolie 6 rahmenartig auf der Rahmenfolie 2 etwa bündig um die Aussparung 3 und das Funktionselement 1 herum angeordnet.

Fig. 5 zeigt einen Querschnitt durch eine zweite Ausgestaltung des Schichtstapels 10, enthaltend die Rahmenfolie 2 mit Funktionselement 1 und Ausgleichsfolie 6 aus Fig. 4. Die übrigen Elemente des Schichtstapels 10 sind wie in den Figuren 2 und 3 ausgebildet. Das Funktionselement ragt aus der Aussparung 3 heraus und steht über die Rahmenfolie 2 über, wobei sich ein Versatz von 70 µm ergibt. Dieser Versatz ist teilweise kompensiert durch die 50 µm dicke Ausgleichsfolie 6, die rahmenartig um das Funktionselement 1 herum angeordnet ist. Es verbleiben zwei Stufen oder Versatze: ein Versatz von 50 µm beim Übergang von der Rahmenfolie 2 zur Ausgleichsfolie 6 und ein Versatz von 20 µm beim Übergang von Ausgleichsfolie 6 zum Funktionselement 1. Beide Versatze sind gegenüber dem ursprünglichen Versatz von 70 µm erfindungsgemäß reduziert. Die Rahmenbreite der Ausgleichsfolie 6, also der Abstand zwischen dem inneren und dem äußeren Begrenzungsrand der Ausgleichsfolie 6, beträgt beispielsweise 30 mm. Dadurch wird die Verbiegung der zweiten Glasscheibe 5 beim Laminieren soweit reduziert, dass Beschädigungen vermieden werden können.

Fig. 6 zeigt einen Querschnitt durch eine weitere Variante des Schichtstapels 10. Das Funktionselement 1 ist hier beispielsweise 500 µm dick und ragt um einen Versatz von 120 µm über die 380 µm dicke Rahmenfolie 2 über. Der Dickenunterschied wird durch zwei jeweils 50 µm dicke Ausgleichsfolien 6.1, 6.2 kompensiert, die rahmenartig um das Funktionselement 1 herum angeordnet sind. Die Rahmenbreite der ersten Ausgleichsfolie 6.1 beträgt beispielsweise 60 mm. Die Rahmenbreite der darüber angeordneten Ausgleichsfolie 6.2 beträgt beispielsweise 30 mm. Die Dicke der Ausgleichsfolien 6.1, 6.2 nimmt also mit wachsendem Abstand zur Rahmenfolie 2 ab, wodurch sich ein pyramidenartiger Aufbau ergibt. Jede Ausgleichsfolie 6.1, 6.2 führt ihrerseits zu einem Versatz von 50 µm und am Rand des Funktionselements 1 verbleibt ein Versatz von 20 µm, was gegenüber dem ursprünglichen Versatz von 100 µm deutlich reduziert ist.

Auch bei Verwendung der rahmenartigen Ausgleichsfolie 6 ist es natürlich möglich, dass die die (oberste) Ausgleichsfolie leicht über das Funktionselement 1 übersteht und ein geringfügiger leerer Raum zwischen dem Funktionselement 1 und der zweiten Verbindungsfolie 8 verbleibt, ähnlich der Situation in Fig. 3.

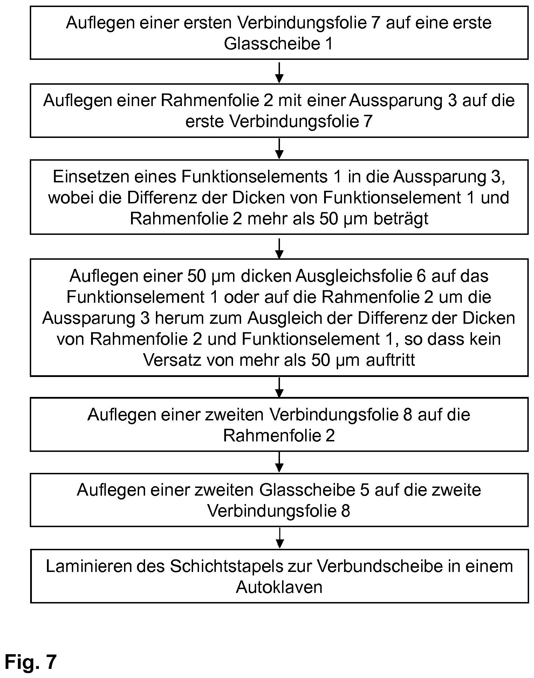

Fig. 7 zeigt ein Ausführungsbeispiel des erfindungsgemäßen Herstellungsverfahrens.

### Bezugszeichenliste:

- (1): Funktionselement
- (2): thermoplastische Rahmenfolie
- (3): Aussparung in der thermoplastischen Rahmenfolie 2
- (4): erste Glasscheibe
- (5): zweite Glasscheibe
- (6): thermoplastische Ausgleichsfolie
- (6.1): erste thermoplastische Ausgleichsfolie
- (6.2): zweite thermoplastische Ausgleichsfolie
- (7): erste thermoplastische Verbindungsfolie
- (8): zweite thermoplastische Verbindungsfolie
- (10): Schichtstapel vor der Lamination zur Verbundscheibe
- (b): Rahmenbreite der Ausgleichsfolie 6

## Patentansprüche

1. Verfahren zur Herstellung einer Verbundscheibe, mindestens umfassend das Anordnen eines Funktionselements (1) in einer Aussparung (3) einer thermoplastischen Rahmenfolie (2), das Anordnen der thermoplastischen Rahmenfolie (2) mit dem Funktionselement (1) zwischen einer ersten Glasscheibe (4) und einer zweiten Glasscheibe (5) zu einem Schichtstapel (10) und das anschließende Verbinden des Schichtstapels (10) zu einer Verbundscheibe durch Lamination,
wobei die thermoplastische Rahmenfolie (2) und das Funktionselement (1) eine unterschiedliche Dicke aufweisen und die unterschiedliche Dicke zumindest teilweise kompensiert wird durch mindestens eine thermoplastische Ausgleichsfolie (6), deren Dicke weniger als doppelt so groß ist wie die Differenz der Dicken der thermoplastische Rahmenfolie (2) und des Funktionselements (1), so dass der maximale Versatz im Schichtstapel (10) geringer ist als die Differenz der Dicken der thermoplastische Rahmenfolie (2) und des Funktionselements (1), wobei gilt:
Alternative (i): die Dicke der thermoplastischen Rahmenfolie (2) ist größer als die Dicke des Funktionselements (1) und wobei die thermoplastische Ausgleichsfolie (6) auf dem Funktionselement (1) innerhalb der Aussparung (3) angeordnet wird, oder
Alternative (ii): die Dicke der thermoplastischen Rahmenfolie (2) ist kleiner als die Dicke des Funktionselements (1) und wobei die thermoplastische Ausgleichsfolie (6) auf der thermoplastischen Rahmenfolie (2) rahmenartig um die Aussparung (3) angeordnet wird, wobei die Dicke der thermoplastischen Ausgleichsfolie (6) geringer ist als der Dickenunterschied zwischen thermoplastischer Rahmenfolie (2) und Funktionselement (1).

2. Verfahren nach Anspruch 1, wobei der maximale Versatz im Schichtstapel (10) kleiner oder gleich der Dicke der Ausgleichsfolie (6) ist.

3. Verfahren nach Anspruch 1 oder 2, wobei der Dickenunterschied zwischen der thermoplastischen Rahmenfolie (2) und dem Funktionselement (1) größer als 50 µm ist und wobei im Schichtstapel (10) kein Versatz von größer als 50 µm auftritt.

4. Verfahren nach Anspruch 1, Alternative (ii), wobei die Breite der rahmenartigen Ausgleichsfolie (6) mindestens das 200-fache der Dicke der Ausgleichsfolie (6) beträgt.

5. Verfahren nach Anspruch 1, Alternative (ii), oder 4, wobei mehrere Ausgleichsfolien (6.1,6.2) übereinander angeordnet und jeweils rahmenartig um die Aussparung (3) angeordnet werden, wobei die Breite der Ausgleichsfolien (6.1,6.2) mit wachsendem Abstand zur Rahmenfolie (2) abnimmt.

6. Verfahren nach einem der Ansprüche 1 bis 5, wobei die thermoplastische Ausgleichsfolie (6) geeignet ist, eine adhäsive Verbindung zur thermoplastische Rahmenfolie (2) und angrenzenden Glasscheiben (4,5) oder angrenzenden weiteren thermoplastischen Schichten herzustellen und bevorzugt Polyvinylbutyral (PVB), Ethylenvinylacetat (EVA) und/oder Polyurethan (PU) enthält.

7. Verfahren nach einem der Ansprüche 1 bis 6, wobei die thermoplastische Ausgleichsfolie (6) einen Weichmacheranteil von kleiner als 15 Gew.-%, bevorzugt kleiner als 10 Gew.-%, besonders bevorzugt kleiner als 5 Gew.-% enthält und bevorzugt im Wesentlichen weichmacherfrei ist.

8. Verfahren nach einem der Ansprüche 1 bis 7, wobei die thermoplastische Ausgleichsfolie (6) eine Dicke von 25 µm bis 100 µm, bevorzugt von 40 µm bis 70 µm, insbesondere etwa 50 µm aufweist.

9. Verfahren nach einem der Ansprüche 1 bis 8, wobei das Funktionselement (1) ein Funktionselement mit veränderlichen optischen Eigenschaften ist, bevorzugt ein Funktionselement mit elektrisch schalt- oder regelbaren optischen Eigenschaften.

10. Verfahren nach Anspruch 9, wobei das Funktionselement (1) ein SPD-, ein PDLC-, ein elektrochromes oder ein elektrolumineszentes Funktionselement ist, bevorzugt ein elektrolumineszentes Funktionselement, besonders bevorzugt ein OLED-Display.

11. Verfahren nach einem der Ansprüche 1 bis 10, wobei zwischen der thermoplastischen Rahmenfolie (2) und der ersten Glasscheibe (4) eine erste thermoplastische Verbindungsfolie (7) und zwischen der thermoplastischen Rahmenfolie (2) und der zweiten Glasscheibe (5) eine zweite thermoplastische Verbindungsfolie (8) angeordnet ist.

## Claims

1. Method for producing a composite pane, at least comprising arranging a functional element (1) in a recess (3) of a thermoplastic frame film (2), arranging the thermoplastic frame film (2) along with the functional element (1) between a first glass pane (4) and a second glass pane (5) to form a layer stack (10), and subsequent joining of the layer stack (10) to form a composite pane by lamination,
wherein the thermoplastic frame film (2) and the functional element (1) have a different thickness and the different thickness is at least partially compensated by at least one thermoplastic compensating film (6), whose thickness is less than twice as large as the difference between the thicknesses of the thermoplastic frame film (2) and the functional element (1) such that the maximum offset in the layer stack (10) is less than the difference between the thicknesses of the thermoplastic frame film (2) and the functional element (1), wherein:
alternative (i): the thickness of the thermoplastic frame film (2) is greater than the thickness of the functional element (1) and wherein the thermoplastic compensating film (6) is arranged on the functional element (1) within the recess (3), or
alternative (ii): the thickness of the thermoplastic frame film (2) is less than the thickness of the functional element (1) and wherein the thermoplastic compensating film (6) is arranged on the thermoplastic frame film (2) like a frame around the recess (3), wherein the thickness of the thermoplastic compensating film (6) is smaller than the difference in thickness between the thermoplastic frame film (2) and the functional element (1).

2. Method according to claim 1, wherein the maximum offset in the layer stack (10) is less than or equal to the thickness of the compensating film (6).

3. Method according to claim 1 or 2, wherein the difference in thickness between thermoplastic frame film (2) and the functional element (1) is more than 50 µm and wherein no offset of more than 50 µm occurs in the layer stack (10).

4. Method according to claim 1, alternative (ii), wherein the width of the frame-like compensating film (6) is at least 200 times the thickness of the compensating film (6).

5. Method according to claim 1, alternative (ii) or 4, wherein a plurality of compensating films (6.1,6.2) are arranged one atop another and are in each case arranged like a frame around the recess (3), wherein the width of the compensating films (6.1,6.2) decreases with increasing distance from the frame film (2).

6. Method according to one of claims 1 through 5, wherein the thermoplastic compensating film (6) is suitable to constitute an adhesive bond to the thermoplastic frame film (2) and adjacent glass panes (4,5) or adjacent other thermoplastic layers and preferably contains polyvinyl butyral (PVB), ethylene vinylacetate (EVA), and/or polyurethane (PU).

7. Method according to one of claims 1 through 6, wherein the thermoplastic compensating film (6) includes a plasticizer content of less than 15 wt.-%, preferably less than 10 wt.-%, particularly preferably less than 5 wt.-% and is preferably substantially plasticizer-free.

8. Method according to one of claims 1 through 7, wherein the thermoplastic compensating film (6) has a thickness of 25 µm to 100 µm, preferably of 40 µm to 70 µm, in particular approx. 50 µm.

9. Method according to one of claims 1 through 8, wherein the functional element (1) is a functional element with variable optical properties, preferably a functional element with electrically switchable or controllable optical properties.

10. Method according to claim 9, wherein the functional element (1) is an SPD, a PDLC, an electrochromic, or an electroluminescent functional element, preferably an electroluminescent functional element, particularly preferably an OLED display.

11. Method according to one of claims 1 through 10, wherein a first thermoplastic bonding film (7) is arranged between the thermoplastic frame film (2) and the first glass pane (4) and a second thermoplastic bonding film (8) is arranged between the thermoplastic frame film (2) and the second glass pane (5).

## Revendications

1. Procédé de fabrication d'un vitrage composite, comprenant au moins la disposition d'un élément fonctionnel (1) dans une cavité (3) d'un film cadre thermoplastique (2), la disposition du film cadre thermoplastique (2) avec l'élément fonctionnel (1) entre une première vitre (4) et une deuxième vitre (5) pour former un empilement de couches (10), et l'assemblage ultérieur de l'empilement de couches (10) pour former un vitrage composite par pelliculage, dans lequel le film cadre thermoplastique (2) et l'élément fonctionnel (1) ont une épaisseur différente et la différence d'épaisseur est au moins partiellement compensée par au moins un film de compensation thermoplastique (6), dont l'épaisseur est moins de deux fois supérieure à la différence entre les épaisseurs du film cadre thermoplastique (2) et de l'élément fonctionnel (1), de sorte que le décalage maximal dans l'empilement de couches (10) est inférieur à la différence entre les épaisseurs du film cadre thermoplastique (2) et de l'élément fonctionnel (1), dans lequel :
variante (i): l'épaisseur du film cadre thermoplastique (2) est supérieure à l'épaisseur de l'élément fonctionnel (1) et le film de compensation thermoplastique (6) est disposé sur l'élément fonctionnel (1) à l'intérieur de la cavité (3), ou
variante ii): l'épaisseur du film cadre thermoplastique (2) est inférieure à l'épaisseur de l'élément fonctionnel (1) et le film de compensation thermoplastique (6) est disposé sur le film cadre thermoplastique (2) comme un cadre autour de la cavité (3), l'épaisseur du film de compensation thermoplastique (6) étant inférieure à la différence d'épaisseur entre le film cadre thermoplastique (2) et l'élément fonctionnel (1).

2. Procédé selon la revendication 1, dans lequel le décalage maximal dans l'empilement de couches (10) est inférieur ou égal à l'épaisseur du film de compensation (6).

3. Procédé selon la revendication 1 ou 2, dans lequel la différence d'épaisseur entre le film cadre thermoplastique (2) et l'élément fonctionnel (1) est supérieure à 50 µm et dans lequel aucun décalage de plus de 50 µm ne se produit dans l'empilement de couches (10).

4. Procédé selon la revendication 1, variante (ii), dans lequel la largeur du film de compensation en forme de cadre (6) est au moins 200 fois supérieure à l'épaisseur du film de compensation (6).

5. Procédé selon la revendication 1, alternative (ii) ou 4, dans lequel plusieurs films de compensation (6.1, 6.2) sont disposés les uns au-dessus des autres et sont dans chaque cas disposés comme un cadre autour de la cavité (3), la largeur des films de compensation (6.1, 6.2) diminuant avec l'augmentation de la distance par rapport au film de cadre (2).

6. Procédé selon l'une des revendications 1 à 5, dans lequel le film de compensation thermoplastique (6) est apte à constituer une liaison adhésive avec le film cadre thermoplastique (2) et les vitres adjacentes (4,5) ou d'autres couches thermoplastiques adjacentes et contient de préférence du butyral de polyvinyle (PVB), de l'éthylène-acétate de vinyle (EVA), et/ou du polyuréthane (PU).

7. Procédé selon l'une des revendications 1 à 6, dans lequel le film de compensation thermoplastique (6) comprend une teneur en plastifiant inférieure à 15 % en poids, de préférence inférieure à 10 % en poids, de préférence moins de 5 % en poids, et est de préférence substantiellement exempt de plastifiant.

8. Procédé selon l'une des revendications 1 à 7, dans lequel le film de compensation thermoplastique (6) a une épaisseur de 25 µm à 100 µm, de préférence de 40 µm à 70 µm, en particulier d'environ 50 µm.

9. Procédé selon l'une des revendications 1 à 8, dans lequel l'élément fonctionnel (1) est un élément fonctionnel à propriétés optiques variables, de préférence un élément fonctionnel à propriétés optiques commutables ou contrôlables électriquement.

10. Méthode selon la revendication 9, dans laquelle l'élément fonctionnel (1) est un SPD, un PDLC, un élément fonctionnel électrochrome ou électroluminescent, de préférence un élément fonctionnel électroluminescent, en particulier un écran OLED.

11. Procédé selon l'une des revendications 1 à 10, dans lequel un premier film de liaison thermoplastique (7) est disposé entre le film cadre thermoplastique (2) et la première vitre (4) et un deuxième film de liaison thermoplastique (8) est disposé entre le film cadre thermoplastique (2) et la deuxième vitre (5).
